# EUROPÄISCHE PATENTANMELDUNG

(11) **EP 1 089 333 A2**
(43) Veröffentlichungstag der Anmeldung: **04.04.2001**
(21) Anmeldenummer: 00203246.4
(22) Anmeldetag: 19.09.2000
(51) Int. Cl.: H01L 23/36

(54) **Gleichrichteranordnung für eine Drehstromlichtmaschine eines Kraftfahrzeuges**

(30) Priorität: 27.09.1999 DE 19946259
(71) Anmelder: Philips Corporate Intellectual Property GmbH, 52064 Aachen (DE); Koninklijke Philips Electronics N.V., 5621 BA Eindhoven (NL)
(72) Erfinder: Thor, Volker, Philips Corp. Intell. Prop. GmbH, 52064 Aachen (DE); Rebergen, Hans, Philips Corp. Intell. Prop. GmbH, 52064 Aachen (DE); Sommerfeld, Peter, Philips Corp. Intel. Prop. GmbH, 52064 Aachen (DE)
(74) Vertreter: Gössmann, Klemens

(57) **Zusammenfassung**

Um eine Gleichrichteranordnung für Drehstromlichtmaschinen von Kraftfahrzeugen mit verbesserten herstellungstechnischen Eigenschaften zu schaffen, wird eine Gleichrichteranordnung mit einem Kühlkörper (1), mit wenigstens einem auf dem Kühlkörper (1) angeordneten Schaltungsträger (2) mit einer elektrisch leitfähig strukturierten Oberfläche, mit wenigstens einer ersten zur Gleichrichtung einer ersten Halbwelle vorgesehenen, auf der elektrisch leitfähig strukturierten Oberfläche eines Schaltungsträgers (2) angeordneten Diode (3) und mit wenigstens einer zweiten zur Gleichrichtung einer zweiten Halbwelle vorgesehenen, auf dem Kühlkörper (1) angeordneten Diode (8) vorgeschlagen.

## Beschreibung

Die Erfindung bezieht sich auf den Aufbau einer Gleichrichteranordnung der Drehstromlichtmaschine eines Kraftfahrzeugs. Bei dem klassischen Prinzip der Drehstromlichtmaschine sind drei gleiche, voneinander unabhängige Windungen u, v, w vorhanden, die räumlich versetzt um 120° angeordnet sind (Stator). Auf dem rotierenden Teil im Inneren (Rotor) sitzt die Erregerwicklung. Sobald ein Erreger-Strom durch die Wicklungen fließt, entsteht ein Magnetfeld, welches wiederum eine dreiphasige Wechselspannung in den Statorwicklungen induziert, die bei Belastung den Drehstrom liefert. Dieser Strom wird mittels einer Brückengleichrichterschaltung gleichgerichtet und dient zur Speisung der Verbraucher und zur Ladung der Batterie. Die Ausgangsspannung der Lichtmaschine wird mittels eines Reglers (Pulsbreitenmodulation des Erregerstromes: PWM) geregelt, d. h. je nach vorhandener Batteriespannung wird der Mittelwert des Erregerstromes eingestellt.

Bekannte elektrische Gleichrichteranordnungen für Kraftfahrzeuganwendungen werden mit speziell gehäusten Dioden aufgebaut, die in metallenen Kühlplatten mechanisch eingepresst (sog. Press-fit-Dioden) oder auf Kühlplatten aufgelötet werden. Die Ausführung der elektrischen und thermischen Verbindung zwischen Dioden und Kühlkörper (meist eine Kühlplatte als Bauteileträger) ist von besonderer Bedeutung, da aufgrund der hohen elektrischen Ströme (typisch ca. 50 A bis 130 A) in den Dioden die Verlustleistung in den beteiligten Bauteilen ausreichend schnell abgeführt werden muss. Die mechanische Verbindung der üblicherweise 8 Dioden untereinander und die elektrischen Anschlüsse werden meistens durch ein mit Kunststoff umspritztes metallenes Stanzgitter ausgebildet.

Um ein Gleichrichter der oben skizzierten Aufbauform zu realisieren, werden Dioden für die verschiedenen Halbwellen auf separate Kühlplatten montiert. Die Komplettmontage ergibt dann eine Gleichrichteranordnung, die Dioden auf verschiedenen Ebenen mit komplexen Leiterträgerkonfigurationen verbindet. Diese Art der Montage ist sehr aufwendig und besteht aus vielen Einzelschritten. Außerdem sind mechanische Prozesse nötig, wie nieten, verschrauben und punktschweißen, die für die elektrischen Komponenten nicht optimal sind.

Die Aufgabe der Erfindung ist es daher, eine Gleichrichteranordnung für Drehstromlichtmaschinen mit verbesserten herstellungstechnischen Eigenschaften zu schaffen.

Die Aufgabe wird durch eine Gleichrichteranordnung für eine Drehstromlichtmaschine eines Kraftfahrzeuges mit einem Kühlkörper, mit wenigstens einem auf dem Kühlkörper angeordneten Schaltungsträger mit einer elektrisch leitfähig strukturierten Oberfläche, mit wenigstens einer ersten zur Gleichrichtung einer ersten Halbwelle vorgesehenen, auf der elektrisch leitfähig strukturierten Oberfläche eines Schaltungsträgers angeordneten Diode, mit wenigstens einer zweiten zur Gleichrichtung einer zweiten Halbwelle vorgesehenen, auf dem Kühlkörper angeordneten Diode gelöst. Die erfindungsgemäße Gleichrichteranordnung nutzt die modulare Aufbauweise aus der Leistungelektronik, um einen Gleichrichter für eine Drehstromlichtmaschine zu realisieren, der eine kompakte und vereinfachte Bauweise ermöglicht. Über ein auf einen Kühlkörper aufgebrachtes Leistungssubstrat (z.B. Direct Bonded Copper, DBC, Substrat) werden nackte Halbleiterdiodenchips (ohne Gehäuse) zu einer Gleichrichteranordnung zusammengefügt. Hierbei befinden sich alle Dioden in einer Ebene und damit können Prozesse aus der Elektronikfertigung wie z.B. Maschinenbestückung, SMD-Löten und Drahtbonden angewandt werden. Daher kann die Fertigung auf normalen Anlagen der Elektronikfertigung ohne spezielle Sondermaschinen durchgeführt werden. Hierbei steht im besonderen die konstruktive Einbindung der Halbleiterdioden des Gleichrichters in den Gesamtaufbau im Vordergrund. Im allgemeinen kann man die Erfindung aber für alle Anwendungen mir Leistungshalbleitern einsetzen.

Der thermische Widerstand des oben beschriebenen Gleichrichteranordnung kann deutlich niedrigere Werte erreichen als bei konventioneller Lösungen. Aufbau- und Verbindungstechnologien sind aus der Elektronikfertigung bekannt. Das Gleichrichteranordnung kann aufgrund seiner Aufbauart und des niedrigen thermischen Widerstands kleiner ausgeführt werden als herkömmliche Lösungen. Mit einer Kühlplatte eignet sich das Modul sehr gut für wassergekühlte Drehstrommaschinen.

Im folgenden soll ein Ausführungsbeispiel der Erfindung anhand von Zeichnungen näher erläutert werden. Dabei zeigen
- Figur 1:: eine schematische Darstellung einer Gleichrichteranordnung mit Bonddrahtverbindungen,
- Figur 2:: eine schematische Darstellung einer Gleichrichteranordnung mit Lotbügeln und
- Figur 3:: eine schematische Darstellung einer Gleichrichteranordnung mit Stanzgittern.

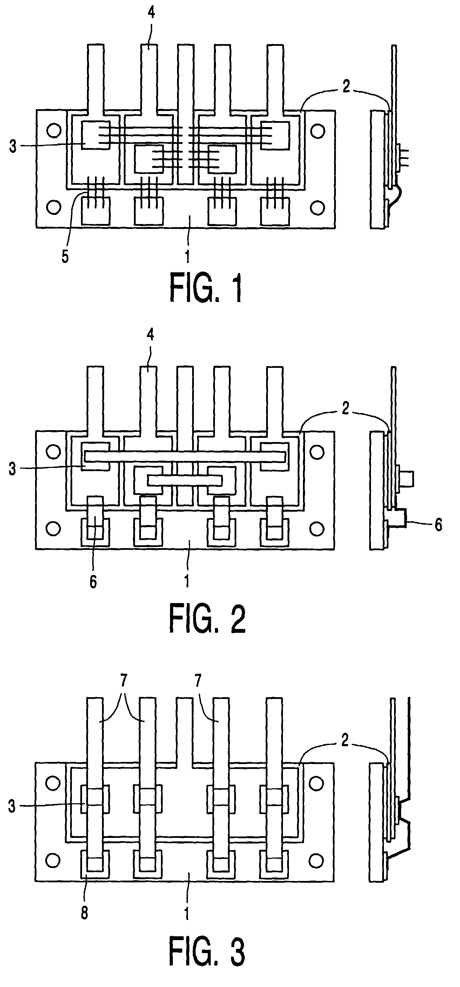

In der Figur 1 eine erfindungsgemäße Gleichrichteranordnung mit Bonddrahtverbindungen schematisch dargestellt. Auf einen Kühlkörper 1 ist ein doppelseitig metallisiertes (z.B. Kupfermetallisierung) Substrat 2 (z.B. Keramik) aufgebracht. Der Kühlkörper 1 kann als Platte ausgeführt sein, bei der die Wärme durch Kontakt zu einer kühlenden Fläche hergestellt wird, oder als mit Rippen ausgestatteter Kühlkörper, der über Luftströmung gekühlt wird. Die Verbindung zwischen Substrat 2 und Kühlkörper 1 soll mit einem wärmeleitfähigen Material ausgeführt werden. Dies kann z.B. eine Lötverbindung sein, bei der durch besondere Prozessführung Luft- und Gaseinschlüsse in der Verbindung reduziert werden.

Die nackten Halbleiterdiodenchips 3 sind auf die Oberseite des Substrats 2 und direkt auf den Kühlkörper 1 gelötet. Sie sorgen für die Gleichrichtung der drei Phasen für beide Halbwellen. Auch beim Auflöten der Diodenchips 3 ist durch besondere Prozessführung auf Minimierung der Luft- und Gaseinschlüsse in der Lötschicht zu achten. Der Kühlkörper 1 bildet elektrisch die Masse des Moduls. Die einzelnen Statorphasen des Drehstromgenerators und der Anschluss für die Batterie werden auf der metallisierten Oberseite des Substrats 2 oder mittels Stanzgitter abgegriffen. Das beidseitig metallisierte Substrat 2 ist seitlich mit Anschlüssen 4 für Batterie und Statorphasen der Drehstromlichtmaschine versehen. Die Metallisierung ist so strukturiert, dass sie Bereiche mit Anschlüssen für die Halbleiterdiodenchips 3 ausformt. Diese werden für eine Halbwelle direkt auf den Kühlkörper 1 gelötet und für die andere auf das Substrat 2. Bonddrahtverbindungen 5 sorgen für die elektrische Kontaktierung der oberen Chipflächen. Diese werden mehrfach ausgeführt, um die hohen Ströme zu tragen. Die gesamte Anordnung kann durch einen Rahmen oder ein Gehäuse eingefasst werden, so dass die Halbleiterdiodenchips 3 durch einen Weichverguss geschützt werden können. Alternativ kann der Aufbau duroplastisch umspritzt werden.

Bei der in der Figur 2 dargestellten Gleichrichteranordnung entspricht der in der Figur 1 gezeigten. Die elektrische Kontaktierung der oberen Halbleiterchipflächen 3 erfolgt hier über Lötbügel 6. Diese haben den Vorteil, dass sie den Strom großflächig aus dem Halbleiter aufnehmen. Dies reduziert den Kontaktwiderstand und damit die Wärmeerzeugung am Halbleiter. Das Setzen der Bügel 6 kann über eine standardmäßige Elektronikbestückung erfolgen, ohne das ein zusätzlicher Prozess wie z.B. Drahtbonden nötig wird.

Bei der in der Figur 3 gezeigten Gleichrichteranordnung hat das beidseitig metallisierte Substrat 2 hat eine obere, durchgehende Fläche zur Aufnahme der Halbleiterdiodenchips 3. Diese werden wie in den anderen Ausführungsbeispielen aufgelötet. Das Substrat 2 und zusätzliche Dioden 8 sind auf den Kühlkörper 1 gelötet. Die Dioden 8 sind an beiden Seiten mit Lötplättchen (z.B. vernickeltes Kupfer) versehen. Dieses erlaubt, dass man Dioden in Mesastrukturtechnik von beiden Seiten großflächig auflöten kann, ohne die Gefahr, Kurzschlüsse zu erzeugen. Die Verbindung zwischen den Dioden 3 und 8 wird durch einzelne Stanzgitter 7 hergestellt, die gleichzeitig den Kontakt für die Statorphasen ausbilden. Diese Stanzgitter 7 werden elektrisch leitfähig (z.B. im Lötverfahren) auf die Dioden 3 und 8 aufgebracht. Ähnlich wie beim in Figur 2 dargestellten Ausführungsbeispiel kann das Modul zum Schluss noch geschützt werden.

## Patentansprüche

1. Gleichrichteranordnung für eine Drehstromlichtmaschine eines Kraftfahrzeuges
- mit einem Kühlkörper (1),
- mit wenigstens einem auf dem Kühlkörper (1) angeordneten Schaltungsträger (2) mit einer elektrisch leitfähig strukturierten Oberfläche,
- mit wenigstens einer ersten zur Gleichrichtung einer ersten Halbwelle vorgesehenen, auf der elektrisch leitfähig strukturierten Oberfläche eines Schaltungsträgers (2) angeordneten Diode (3),
- mit wenigstens einer zweiten zur Gleichrichtung einer zweiten Halbwelle vorgesehenen, auf dem Kühlkörper (1) angeordneten Diode (8).
